# EUROPEAN PATENT APPLICATION

(11) **EP 2 308 811 A1**
(43) Date of publication of application: **13.04.2011**
(21) Application number: 10251648.1
(22) Date of filing: 24.09.2010
(51) Int. Cl.: C04B 35/565, C04B 35/584, C04B 35/80, C04B 35/571, C04B 35/628, C04B 35/626

(54) **Hybred polymer CVI composites**

(30) Priority: 24.09.2009 US 566339
(71) Applicant: United Technologies Corporation, Hartford, CT 06101 (US)
(72) Inventor: Kmetz, Michael A., Colchester, CT 06415 (US); Newton, Kirk C., Enfield, CT 06082 (US)
(74) Representative: Hall, Matthew Benjamin

(57) **Abstract**

A method of forming a highly densified chemical matrix composite CMC from a preform of a matrix of a non-oxide ceramic and continuous ceramic fibers. An interface coating is added, followed by partially densifying the preform with a resin to increase the density of the preform using a polymer infiltration pyrolysis PIP) process one or more times. A chemical vapor infiltration (CVI) process is used to bring the CMC to a final desired density.

## Description

The present invention relates to a family of materials commonly referred to as non-oxide ceramic matrix composites (hereinafter CMC).

CMC materials are used in many applications where there is a hot structure in the presence of an air breathing or oxidizing environment, such as gas turbine blades, turbine exhaust systems, vanes, shrouds, liners, hypersonic vehicles where the leading edge is in an oxidizing environment, and the like.

These materials are typically comprised of a matrix phase composed of a non-oxide ceramic such as silicon carbide (SiC), silicon nitride (Si₃N₄) or mixed ceramic phases such as silicon carbo-nitride (SiNC). The matrix phases are reinforced with continuous ceramic fibers, typically SiC type such as Nicalon^{™} CG grade, Hi Nicalon^{™}, Nicalon^{™} type-s, Ube^{™}, or Sylramic^{™}, etc. These materials may or may not be stoichiometric or completely crystalline. The presence of less or more than a full stoichiometric amount simply means that there is an excess of one or the other of silicon or carbon, creating, for example, zones of amorphous materials.

Recent developments in manufacturing have looked into the ability to coat large quantities of woven ceramic cloth with an interfacial coating that provides the proper de-bonding properties needed to fabricate high temperature composites. This interfacial coating material, such as carbon or boron nitride, acts as a de-bonding agent, providing a weak bond between the fiber and the matrix, which in turn provides a toughening mechanism for the CMC.

To date the most effective method for depositing the fiber interface on the ceramic cloth is by the chemical vapor infiltration (CVI) process. The CVI process is a non-line-of-sight coating process that has the ability to produce highly dense coatings ranging from several angstroms to several inches in thickness.

In the past, either CVI or Polymer Infiltration Pyrolysis (PIP) processes have been used to fabricate CMC materials. When either process is used, the interface coating has been applied via a CVI process to a dry fiber preform.

In the traditional CVI process, ceramic cloth is layed-up and compressed in graphite tooling to create a dry fiber preforms, followed by the deposition of the interface coating. It requires a considerable amount of force to compress the plies together to achieve the desired fiber volume (from around 30 to 40%). Due to the stiffness of coated cloth as opposed to non-coated cloth, the force needed to compress the coated plies together is extremely high and difficult to obtain. This is why the interface coating is almost exclusively applied in the graphite tooling. When considering large composites, this limits the process to uncoated cloth. In addition, complex shapes are difficult to fabricate due to the complex tooling needed to form the shape. This method does not allow full utilization of PMC (Polymer Matrix Composite) composite preform fabrication techniques and adds to production costs.

After the interface coating has been deposited, the coated preform is either removed from the tooling at this point or left in the tooling, depending on the thickness of the interface coating. If the preform is not removed from the tooling, then matrix material is usually infiltrated until there is sufficient ply-to-ply bonding to hold the preform together. Once a free standing preform is obtained, additonal matrix material is infiltrated into the fiber preform. The benefits of this process are (1) high density of around 95% of theoretical, (2) closed porosity, (3) the matrix is grown around the fiber interface, and (4) the matrix may be an amorphous or crystalline material.

In the PIP process, a fiber perform / green body is fabricated from previously interface coated fabric through the layup and forming of the desired shape and impregnation with and subsequent curing of a pre-ceramic polymer. The fabrication of this green body utilizes mature manufacturing techniques that are employed in the mass production of polymer matrix composites such as Resin Transfer Molding (RTM), pre-preg layup and vacuum bagging or compression molding. The green body is then pyrolysed in a controlled atmosphere to convert the polymer to a ceramic char. In this process only around 70 % to 80 % of the polymer is converted to a ceramic material accompanied by the related shrinkage due to out-gassing and material density increase due to conversion from polymer to ceramic. Therefore, multiple impregnation and pyrolysis cycles (up to 9 to 12) are needed to obtain a high density. In addition, the evolution of gaseous species during the polymer-to-ceramic convention process produces an appreciable amount of open porosity. This open porosity provides a pathway into the composite for oxidation. One of the highlights of the PIP process is the ability to use conventional methods like injection molding and RTM processes to manufacture the green body. This technology is well known from the plastic industry and can be easily adapted to inorganic polymers. This process provides the ability to form reproducible complex shapes and sizes.

The PIP process for CMC fabrication has the advantage of using proven PMC type processes, such as RTM, prepreg layup, etc. These processes have been successfully automated to produce high quality/quantity composites at low costs. The drawbacks to current PIP processing of CMC's is the resulting micro-cracked/micro-porous matrix that reduces thermal conductivity and provides a path for oxygen ingress and the resulting environmental degradation of the composite. The CVI approach to CMC fabrication has the advantage of producing a highly dense, crystalline matrix. This results in improved preformance and lends itself to advanced manufacturing concepts that incorporate self-sealing systems into the manufacturing process. The CVI approach suffers from labour intensive assembly of the preform into the required tooling to hold the preform together until there is enough CVI matrix to make the structure free standing. This initial stage of traditional CVI processing does not lend itself to easy automation for volume production and the required graphite tooling makes the fabrication of highly complex shapes very difficult and expensive.

The present invention provides a method to use PIP and CVI composite manufacturing processes combined in such a way to enable a low cost/high volume approach to advanced CMC materials.

Viewed from a first aspect, the present invention provides a method of forming a highly densified ceramic matrix composite (CMC), comprising: forming a preform of a matrix formed from a non-oxide ceramic and continuous ceramic fibers and adding an interface coating; partially densifying the preform with a resin to increase the density of the preform using a polymer infiltration pyrolysis (PIP) process; and infiltrating the preform using a chemical vapor infiltration process (CVI) to a final density.

The method includes the combination of both PIP and CVI to incorporate the efficiency of automation and large volume production of PIP processing to form a complex shape, free standing CMC body, then complete the matrix infiltration with a CVI process to achieve the enhanced properties of a CVI CMC with a low cost/high volume process. The number of PIP cycles used, and the subsequent amount of CVI infiltration that is performed is dependant on the application and the desired properties. The technique can be used to form an essentially 100% CVI based composite, or conversely used to add some environmental protection to a PIP based CMC through infiltration of the micro-porosity in the matrix.

The invention comprises a method of forming a highly densified CMC composite by forming a preform of a matrix formed from a non-oxide ceramic and continuous ceramic fibers and adding an interface coating. The preform is partially densified with a resin to increase the density thereof using a PIP process. Then, the preform is infiltrated using a CVI process to a final density.

Viewed from another aspect, the present invention provides a method of forming a highly densified ceramic matrix composite (CMC) composite, comprising: forming a preform from a plurality of layers of a ceramic fiber impregnated with a resin the plurality of layers being layed-up on a predetermined orientation to form a green composite having desired shape; partially densifying the preform with a resin to increase the density of the preform using a polymer infiltration pyrolysis (PIP) process decompose to form ceramic char; and infiltrating the preform using a process chemical vapor infiltration (CVI) process to a finally density of at least 95% of theoretical.

Viewed from a further aspect, the present invention provides a highly densified ceramic matrix composite (CMC) having a final density that has been formed by: forming a preform of a matrix formed from a non-oxide ceramic and continuous ceramic fibers and adding an interface coating; partially densifying the preform with a resin to increase the density of the preform using a polymer infiltration pyrolysis (PIP) process; and infiltrating the preform using a chemical vapor infiltration (CVI) process to a final density.

Certain preferred embodiments of the present invention will now be described in greater detail by way of example only and with reference to the accompanying drawings, in which:
FIGURE 1 is a block diagram of a CVI reactor used on PIP composites;
FIGURE 2 is a graph showing the results of tests on experimental samples;
FIGURE 3 is a SEM fractograph of an experimental sample;
FIGURE 4 is a SEM micrograph of a CMC composite of this invention; and
FIGURE 5 is another SEM micrograph of another CMC composite of this invention.

The method of this invention includes the use of both a PIP process and a CVI process.

In the PIP process, a fiber perform / green body is fabricated from CVI interface coated fibers or fabric by impregnation with and subsequent curing of an inorganic polymer. The fabrication of this green body utilizes established manufacturing techniques that are employed in the mass production of polymer matrix composites such as the previously mentioned RTM, pre-preg layup, and vacuum bagging. The green body is then pyrolysed in a controlled atmosphere to convert the polymer to a ceramic char. In this process only around 70 % to 80 % of the polymer is converted to a ceramic material. Therefore, multiple impregnation and pyrolysis cycles (such as up to 9 to 12 cycles) are needed to obtain a desired high density of 90% to essentially 100%. In addition, the evolution of gas species during the polymer to ceramic convention process produces an appreciable amount of open porosity. This open porosity provides a pathway into the composite for unwanted oxidation. Still, one of the highlights of the PIP process is the ability to use conventional methods like injection molding and RTM process to manufacture the green body. This technology is well known from the plastic industry and is easily adapted to inorganic polymers. This process provides the ability to form reproducible complex shapes and sizes.

In the CVI process, ceramic cloth is layed-up and compressed in graphite tooling to create a dry fiber preform, followed by the deposition of the interface coating. When considering large or complex composites, complex and costly graphite tooling is typically required to ensure proper fiber volume fraction and preform shape, while allowing uniform CVI infiltration for the interface coating and CVI matrix. This tooling is designed to be reusable, but due to the nature of the CVD process, its lifetime is limited to a finite number of components that is significantly shorter than tooling used in PIP processing. This method does not allow full utilization of PMC composite preform fabrication techniques and adds to production costs.

The present invention employs the advantages of both the PIP process and the CVI process to produce an improved product in a much more economical method.

In order to evaluate the present invention, experimental composites were prepared and compared. In a first process, eight plies of Nicalon^{™} fabric (previously coated with a duplex BN/Si₃N₄ fiber coating) were impregnated with a polysilazane resin (COIC S-200) containing less than fifteen percent 30µm α-silicon nitride filler. The plies of fabric were layed-up in a warp aligned symmetric orientation and were impregnated using standard vacuum bag processing techniques. After impregnation, the green composites were put through a standard pyrolysis cycle to decompose the polymer into a ceramic char. Typically, this process reached temperatures greater than one thousand degrees Celsius.

One composite labeled "green body" was subjected only to the first impregnation and pyrolysis cycle. Another composite denoted "three impregnations" went through this impregnation and pyrolysis cycle three times. The number of times that the composite went through the cycle corresponds directly to the name of the composite.

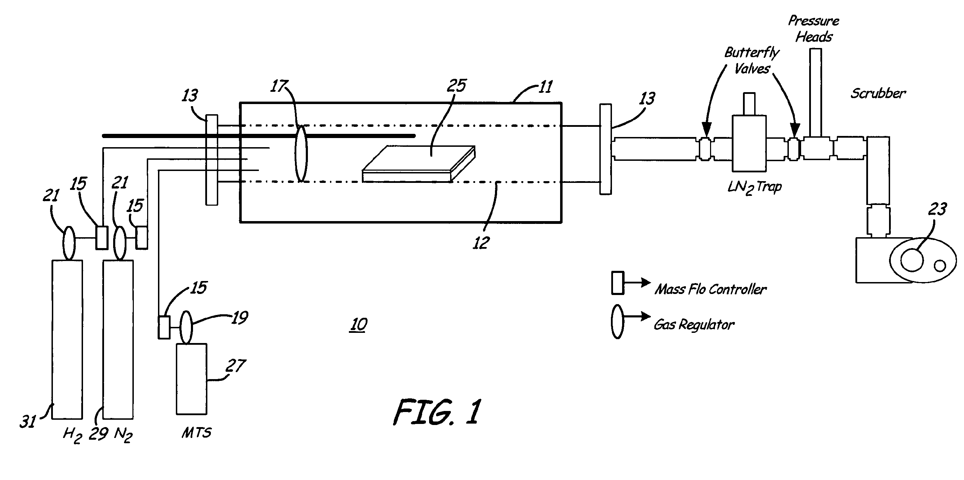

Silicon carbide was infiltrated into the partially densified composites by use of a hot wall low pressure CVD reactor. Figure 1 presents a representation of the reactor, 10 generally. Reactor 10 includes a fused silica (quartz) tube 8 ¼" inches (210 mm) in diameter 11 with a graphite insert 12 that was 7 ¼" inches (185 mm) in diameter. The graphite insert was used to protect the quartz tube from reacting with the SiC. Water cooled stainless steel end caps 13 with fluoroelastomer (Viton®) O-rings and Swagelok^{™} compression fitting were used to seal off the reactor and deliver the gasses. MKS^{™} Mass Flo Controllers (MFC's) 15 and a Grafoil^{™} diffuser 17 were used to control the path and flow of gaseous precursors. A MKS^{™} throttling valve 19 and several MKS^{™} baratron absolute pressure transducers 21 were used to monitor and control the pressure inside the reactor. A liquid nitrogen and particulate trap were used to collect the by-products. A Leybold Trivac^{™} D60 vacuum pump 23 provided the vacuum.

The composites were infiltrated with SiC by first placing the PIP composites 25 twenty inches (0.51 m) inside of the reactor on a graphite holder. Gas diffuser 17 was placed approximately two inches (51 mm) in front of the composite 25 and the injector rod for the MTS vapor 27 was located around two inches (51 mm) in front of the diffuser. The reactor was initially pumped down to a base pressure of less than 1 mTorr (0.133 Pa) then back filled three times with ultra high purity nitrogen 29 to remove any oxygen from the system. The chamber was isolated from the pumped and the reactor was checked for leaks until a leak rate of 300 mTorr/hour (40 Pa/hour) or less was obtained. The reactor was then brought up to deposition temperature of 1050°C in flowing nitrogen (50 sccm (84.5x10³Pam³/s) at a rate of 50°C/min. After equilibration, the nitrogen flow rate was increased to 400 sccm (676x10⁻³ Pam³/s) and ultra high purity hydrogen 31 was introduced into the reactor at a flow rate of 400 sccm (676x10⁻³ Pam^{3/}s). After several minutes, the pressure was stabilized to 6 torr (0.8 Pa) and Methyltrichlorosilane (MTS) 27 was allowed to flow into the reactor at a rate of 50 to 70 sccm (84.5x10⁻³ to 118x10⁻³ Pam³/s). A liquid nitrogen trap was used to trap low molecular weight polysilanes along with other volatile compounds. Table 1 presents the experimental matrix that was used to fabricate the four composites used in this study.

**Table 1 Experimental parameter used to infiltrate the composites**

| Run | Tem. °C | MTS sccm* | H₂ sccm* | N₂ sccm* | Pressure (torr)⁺ | Infiltration Time (hours) | Infiltration Rate (g/hr) |
|---|---|---|---|---|---|---|---|
| Green Body | 1050 | 50 | 400 | 400 | 6.00 | 150 | ---- |
| One Impregnation | 1050 | 65-70 | 400 | 400 | 6.00 | 115 | 0.17 |
| Three Impregnations | 1050 | 65-70 | 400 | 400 | 6.00 | 115 | 0.11 |
| Five Impregnations | 1050 | 65-70 | 400 | 400 | 6.00 | 50 | 0.13 |

| | | | | | | | |
|---|---|---|---|---|---|---|---|
| * 1 sccm = 1.69x 10⁻³Pam³/s + 1 torr = 0.133Pa | | | | | | | |

Table 1 presents the results of the infiltration times versus the partial densification for the four composites fabricated. The green body possesses the greatest amount of porosity and took the longest time to infiltrate with CVI SiC. Composites labeled, "One Impregnation and Three Impregnation" were infiltrated in the same run. The difference in the post CVI densities for the two composites is most likely related to the higher density of CVI SiC over that of the polymer ceramic char. The composite labeled," five impregnation" had the highest initial density and took only around 50 hours to infiltrate.

Table 2 presents the bulk density and % open porosity before and after the densification processes on the four different composites. In all measured samples, the open porosity was decreased significantly after the CVI process.

**Table 2 Bulk density and % open porosity before and after infiltration**

| Composite | Bulk Density (g/cm³) | Bulk Density (g/cm³) | % Increase in Density | % Open Porosity | % Open Porosity |
|---|---|---|---|---|---|
| | Pre-CVI | Post CVI | | Pre-CVI | Post CVI |
| Green Body | 1.7 | 2.134 | 26% | | 10.662% |
| One Impregnation | 1.810 | 2.137 | 15% | 27.061% | 13.700% |
| Three Impregnations | 1.952 | 2.121 | 8.0% | 18.415% | 10.514% |
| Five Impregnations | 1.944 | 2.123 | 8.4% | 11.809% | 7.836% |

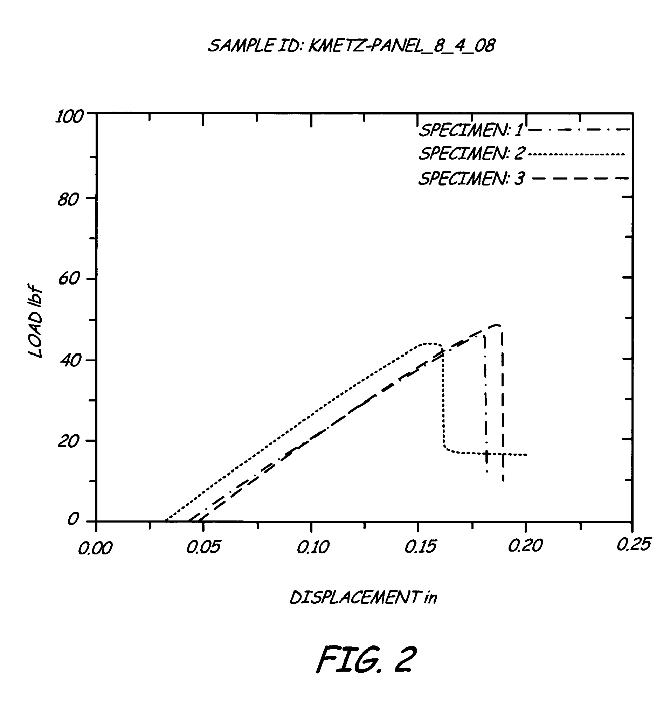

Figure 2 presents the results of the 4-point bend test on three samples cut from the composite designated "green body" after one, three and five impregnations respectively. The strengths of the composites presented in Figure 2 were compared with composites that were infiltrated using only the PIP process using the same fiber lot and the same fiber coating run. The results of the 4-point bend testing showed that the strengths of the PIP/CVI composites were at the upper end of the strength range.

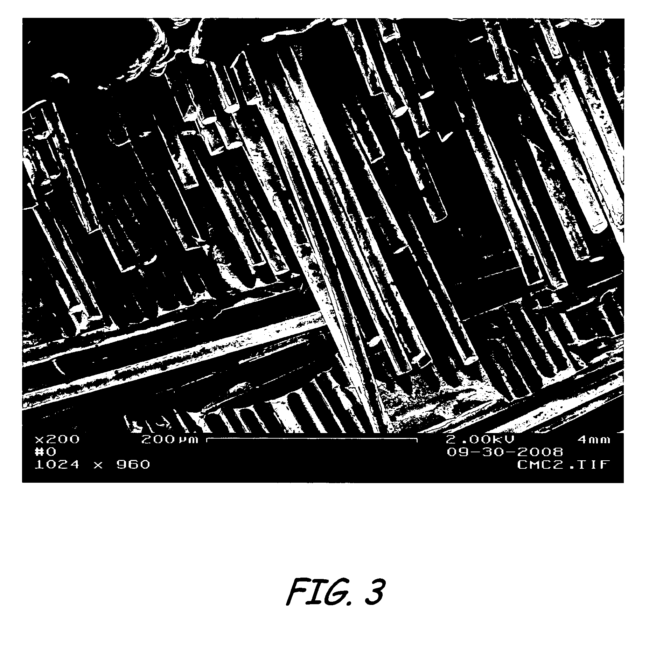

Figure 3 presents a SEM fractograph of the one of the PIP/CVI composites (labelled green body) after bend testing. This composite shows a consider amount of fiber pullout which supports the displacement section of the cure shown in Figure 2. The extent of fiber pullout indicates a tough composite. Both of these results showed that the process of infiltrating the partially infiltrated PIP composites with CVI SiC did not affect the strength or toughness of the composites.

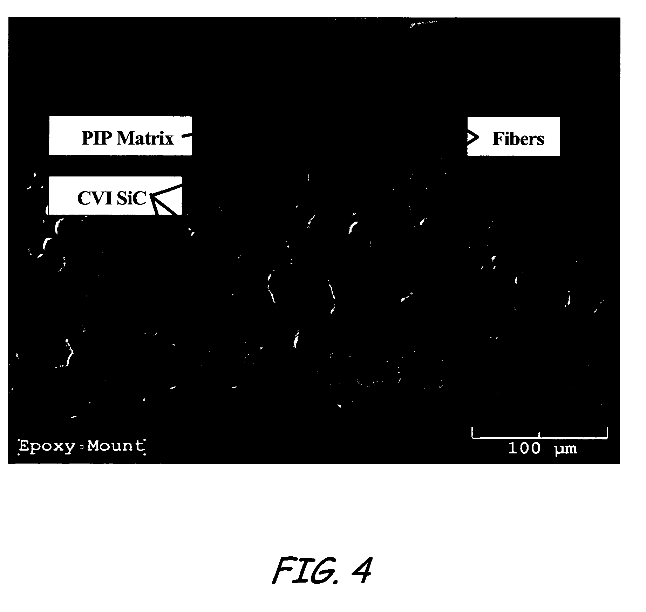

Figure 4 presents a SEM micrograph of a polished section of the first composite (labelled green body) after the CVI process. The lighter area of the matrix shown in the micrograph has been attributed to CVI deposited SiC. The SiC can be seen enveloping the outside of the composite indicating the composite was "canned off" during the CVI process. This canning off process prevents additional SiC from infiltrating into the composite and filling up the remaining porosity. This is a common occurrence in the CVI process and can be minimized by reducing the deposition rate. Even though the composite was canned off during the CVI process, a considerable amount of opened porosity was filled in with SiC.

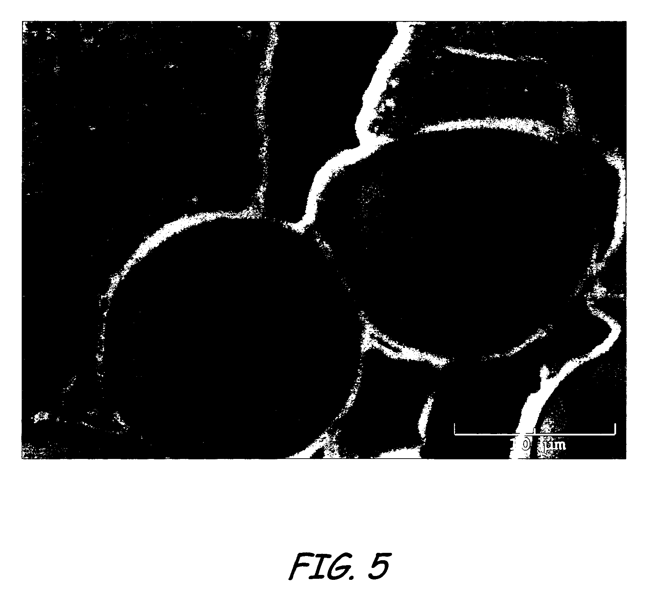

Figure 5 presents a SEM micrograph of a PIP/CVI composite. The lighter areas around the fiber show the CVI SiC infiltrating through an open pore and around the fibers as is desired.

In summary, the ability to fabricate ceramic matrix composites using the PIP/ CVI process was demonstrated. Several different PIP composites were fabricated to various densities. These composites were then infiltrated in a CVI process with SiC to a final density of around 2.1 g/cm³. Four-point bend testing showed that the strength of the composite was not affected by the CVI process. SEM fractographs of the composites after testing showed a considerable amount of fiber pullout. SEM micrograph of the polished surface of the composites showed that the CVI process was able to penetrate into the partially impregnated composites and fill in some of the micro-porosity.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A method of forming a highly densified ceramic matrix composite (CMC), comprising:
forming a preform of a matrix formed from a non-oxide ceramic and continuous ceramic fibers and adding an interface coating;
partially densifying the preform with a resin to increase the density of the preform using a polymer infiltration pyrolysis (PIP) process; and
infiltrating the preform using a chemical vapor infiltration process (CVI) to a final density.

2. The method of claim 1, wherein the preform is formed from a plurality of layers of a ceramic fiber impregnated with a resin, the plurality of layers being layed-up on a predetermined orientation to form a green composite having desired shape.

3. The method of claim 2, wherein the impregnated resin is decomposed to ceramic char.

4. The method of claim 3, wherein the green composite is impregnated and decomposed a plurality of times to form a densified preform.

5. The method of any preceding claim, wherein the preform is infiltrated by the CVI process to increase the density and reduce porosity of the CMC composite.

6. The method of any preceding claim, wherein the non-oxide ceramic is selected from the group consisting of silicon carbide, silicon nitride, silicon carbo-nitride and mixtures thereof.

7. The method of any preceding claim, wherein the ceramic fiber is formed from continuous silicon carbide fiber.

8. The method of any preceding claim, wherein the composite has a final density of at least 90% of theoretical.

9. The method of claim 8, wherein the composite has a final density of at least 95% of theoretical.

10. A highly densified ceramic matrix composite (CMC) having a final density that has been formed by:
forming a preform of a matrix formed from a non-oxide ceramic and continuous ceramic fibers and adding an interface coating;
partially densifying the preform with a resin to increase the density of the preform using a polymer infiltration pyrolysis (PIP) process; and infiltrating the preform using a chemical vapor infiltration (CVI) process to a final density.

11. The composite of claim 10, wherein the preform has been formed from a plurality of layers of a ceramic fiber impregnated with a resin the plurality of layers being layed-up on a predetermined orientation to form a green composite having desired shape.

12. The composite of claim 10 or 11, wherein the densifying resin has been decomposed to form ceramic char during the production of the ceramic matrix composite.

13. The composite of claim 10, 11 or 12, wherein the green composite has been impregnated and decomposed a plurality of times to form a densified preform during the production of the ceramic matrix composite.

14. The composite of any of claims 10 to 13, wherein the preform has been infiltrated by the CVI process to increase the density and reduce porosity of the CMC composite during the production of the ceramic matrix composite.

15. The composite of claim 14, wherein the non-oxide ceramic has been selected from the group consisting of silicon carbide, silicon nitride, silicon carbo-nitride and mixtures thereof, and more preferably the ceramic fiber has been formed from continuous silicon carbide fiber.
